## Europäisches Patentamt
## European Patent Office
## Office européen des brevets

(11) Numéro de publication: **0 063 989**
**B1**

(12) **FASCICULE DE BREVET EUROPÉEN**

---

(45) Date de publication du fascicule du brevet:
**15.01.86**

(21) Numéro de dépôt: **82400653.0**

(22) Date de dépôt: **09.04.82**

(51) Int. Cl.⁴: **C 03 C 17/02, G 01 T 1/20**

---

(54) Procédé d'obtention de couches de verres luminescents, application à la réalisation de dispositifs munis de ces couches et à la réalisation de photo-scintillateurs.

---

(30) Priorité: **15.04.81 FR 8107566**

(43) Date de publication de la demande:
**03.11.82 Bulletin 82/44**

(45) Mention de la délivrance du brevet:
**15.01.86 Bulletin 86/3**

(84) Etats contractants désignés:
**BE DE GB**

(56) Documents cité:
DE-A-2 418 483
FR-A-1 244 332
FR-A-1 252 561
GB-A-905 391

NUCLEAR INSTRUMENTS AND METHODS, vol. 148, no. 2, janvier 1978, North-Holland Publishing Co. (NL), M. POULET et al. "An air light guide, plastic scintillation counter", pages 359-362
LE VIDE "LES COUCHES MINCES, supplement no. 196, 1979, C. SELIA et al.: "Module de pulvérisation multimode", page 211
HANDBOOK OF THIN FILM TECHNOLOGY, chap. 4, Leon Maissel, pages 1,2 et 17-41

(73) Titulaire: **COMMISSARIAT A L'ENERGIE ATOMIQUE Etablissement de Caractère Scientifique Technique et Industriel, 31/33, rue de la Fédération, F-75015 Paris (FR)**
Titulaire: **CENTRE NATIONAL DE LA RECHERCHE SCIENTIFIQUE, 26, rue Boyer, F-75020 Paris (FR)**

(72) Inventeur: **Heindl, Rudolf, 12, rue des Fauvettes, F-92260 Fontenay- Aux- Roses (FR)**
Inventeur: **Robert, André, 4 bis, Avenue de Noailles, F-78320 Le Mesnil Saint Denis (FR)**
Inventeur: **Sella, Claude, 13, Avenue Woluwé Saint Lambert, F-92360 Meudon La Foret (FR)**

(74) Mandataire: **Mongrédien, André, c/o BREVATOME 25, rue de Ponthieu, F-75008 Paris (FR)**

---

## Description

La présente invention concerne un procédé d'obtention de couches minces de verres luminescents. Elle s'applique en particulier à la réalisation de dispositifs munis d'au moins une couche mince de verre luminescent tels que certains dispositifs d'éclairage, les tubes cathodiques, les tubes amplificateurs d'images, les écrans de radiographie X et les écrans de télévision. Elle s'applique également à la réalisation de photoscintillateurs comprenant une couche mince de verre scintillant sur un support, cette couche étant apte à émettre de la lumière par absorption d'énergie et optiquement couplée à un photodétecteur muni d'une fenêtre d'entrée.

De tels photoscintillateurs sont utilisables notamment pour la mesure du taux d'émission de particules α de solutions liquides acides utilisées dans l'élaboration des actinides et pour le contrôle en continu des effluents radioactifs issus d'usines de retraitement de combustibles irradiés provenant de réacteurs nucléaires.

On sait en effet, qu'il est fréquent d'avoir à déterminer le taux d'émission de particules α de substances en solution dans un liquide tant dans le domaine de la recherche que dans l'industrie nucléaire. Dans le cas où la solution à étudier est corrosive et en circulation et présente simultanément des radioactivités α, β et/ou γ, la technique de détection des particules α utilisant un photoscintillateur comprenant une couche de verre scintillant optiquement couplée à la fenêtre d'entrée d'un photodétecteur tel qu'un photomultiplicateur, présente de grands avantages par rapport aux autres techniques connues de détection de particules α, notamment une bonne résistance du verre (à haute teneur en silice $SiO_2$) aux réactifs organiques ou inorganiques tels que des solutions corrosives d'acide nitrique. Cette bonne résistance du verre permet d'utiliser un montage de détection dans lequel la couche de verre scintillant, placée contre la fenêtre d'entrée du photomultiplicateur, est en contact direct avec la solution étudiée, et d'éliminer ainsi les systèmes munis d'une fenêtre de séparation fragile et capable de se déformer, le photoscintillateur ne voyant plus alors la portion de solution analysée sous le même angle solide. Un tel montage, du fait de sa robustesse, présente par ailleurs l'avantage d'être bien adapté à une circulation de liquide pouvant comporter des variations de débit et donc de pression au niveau de la couche de verre scintillant.

Pour un liquide à la fois émetteur α, β et/ou γ, une bonne discrimination des particules α vis-à-vis des particules β et/ou des photons γ peut être obtenue en limitant la portion de liquide étudié à une couche de faible épaisseur, de l'ordre de quelques millimètres, de façon que peu de particules β et/ou de photons γ soient émis et en donnant à l'épaisseur de la couche de verre scintillant une valeur de l'ordre du parcours, dans le verre scintillant, correspondant à l'énergie d'émission des particules α à détecter. Ce parcours peut être inférieur à 20 μm, par exemple de l'ordre de 1 à 15 μm.

Or, les procédés connus de réalisation de couches minces de verre scintillant ne permettent pas d'obtenir, d'une façon reproductible, des valeurs aussi faibles pour l'épaisseur de ces couches. En particulier,

- le procédé de fusion d'une couche mince de verre scintillant sur un support permet difficilement de conserver les teneurs initiales du verre en composés responsables de la scintillation durant la mise en oeuvre de ce procédé et l'on ne peut guère obtenir une épaisseur de couche inférieure à 300 μm avec ce procédé car en utilisant trop peu de matière pour réaliser la couche mince, la composition finale de celle-ci (après fusion) est trop différente de la composition initiale prévue pour obtenir un verre scintillant; et

- l'abrasion mécanique de verres permet d'amincir ces derniers jusqu'à 250 μm et les résultats obtenus en poursuivant cette abrasion jusqu'à une quarantaine de micromètres, ce qui représente une difficulté certaine, sont très aléatoires. De plus, les couches minces ainsi obtenues sont difficilement fixables sur la fenêtre d'entrée d'un photomultiplicateur.

La présente invention a pour but de remédier à cet inconvénient.

Elle a pour objet un procédé d'obtention de couches minces de verres luminescents, caractérisé en ce qu'il consiste à projeter sur un support, par pulvérisation cathodique, en athmosphère réductrice, de la matière d'au moins une cible, chaque cible comprenant de la silice et au moins un composé chimique apte à donner des centres luminescents, de façon à former au moins une couche mince de verre luminescent sur ledit support.

On peut ainsi obtenir de façon reproductible des couches minces de verre luminescent, d'épaisseur désirée par exemple de l'ordre de 10 à 20 micromètres.

Une ou plusieurs cibles, contenant chacune un ou plusieurs composés chimiques aptes à donner des centres luminescents, peuvent être utilisées de façon à former, sur le support, une seule couche (ou couche simple) d'un verre luminescent donné ou, successivement, plusieurs couches (ou dépôt multicouche) composées de verres luminescents différents.

Ladite matière est donc projetée à l'aide d'un bombardement de chaque cible par des corpuscules destinés à arracher cette matière à chacune des cibles. Lesdits corpuscules peuvent être neutres ou chargés. Ils comprennent par exemple des molécules ionisées d'un gaz tel que $N_2$ ou des atomes ionisés de gaz rares comme l'argon.

L'atmosphère réductrice est par exemple constituée d'un gaz inerte tel que l'argon, additionné d'hydrogène. Dans le cas particulier d'un verre luminescent au cérium, cette atmosphère réductrice favorise la formation de centres $Ce^{3+}$ luminescents.

Selon des caractéristiques particulières du procédé objet de l'invention, celui-ci consiste en outre à effectuer un traitement thermique, tel qu'un recuit, de la (ou des) couche(s) formée(s), pendant sa (leur) formation, par exemple par chauffage du support, ou après sa (leur) formation. Dans le cas particulier d'un verre luminescent au cérium, un recuit, en plaçant la plupart des atomes de cérium dans l'état $Ce^{3+}$, permet d'augmenter, dans des proportions considérables, la quantité de lumière émise par une couche de verre luminescent formée, lorsqu'elle a absorbé de l'énergie.

Ledit traitement thermique peut être effectué en atmosphère inerte, par exemple une atmosphère d'argon, ou en atmosphère reductrice par exemple composée d'un gaz inerte tel que l'argon, additionné d'hydrogène.

Le document "Handbook of thin film technology", chap. 4, L. MAISSEL, p. 1, 2 et 17-41 traite de l'application de la pulvérisation au dépôt de films, mais ne concerne pas la fabrication de verres luminescents.

Selon une autre caractéristique particulière du procédé objet de l'invention, chaque composé chimique apte à former des centres luminescents comprend au moins un élément de la famille des Terres Rares. Cet élément peut être le cérium. (Dans le cas de la réalisation de dépôts multicouches, on utilise par exemple plusieurs composés à base de Terres Rares différents et dans celui de la réalisation d'une couche simple de verre luminescent, on peut par exemple utiliser un composé à base de cérium comme $CeO_2$ ou $Ce_2O_3$ ou même un mélange de ces deux oxydes).

Comme on l'a déjà mentionné, le procédé objet de l'invention s'applique à la réalisation de photoscintillateurs comprenant une couche mince de verre scintillant sur un support, cette couche (formée par le procédé objet de l'invention) étant apte à émettre de la lumière par absorption d'énergie et optiquement couplée à un photodétecteur muni d'une fenêtre d'entrée. Ce photodétecteur est par exemple un photomultiplicateur.

Par verre scintillant, on entend un verre luminescent qui, excité par absorption d'énergie (par exemple sous forme de particules $\alpha$ ou $\beta$ ou de photons $\gamma$) en restitue au moins une partie sous forme de lumière, cette restitution ayant lieu pendant un instant très court (en général inférieur à $10^{-6}$s) après la fin de l'excitation.

Un photoscintillateur est par exemple utilisé pour la détection de particules $\alpha$, $\beta$ ou de photons $\gamma$.

Ledit support de la couche de verre scintillant peut être la fenêtre d'entrée préalablement dépolie du photodétecteur. (Cette fenêtre, transparente à la lumière que la couche de verre scintillant peut émettre lorsqu'elle est excitée, permet ainsi au photodétecteur de capter cette lumière pour la convertir en courant électrique).

Ledit support de la couche de verre scintillant peut également être transparent à la lumière que cette couche de verre scintillant est apte à émettre et destiné à être optiquement couplé à la fenêtre d'entrée du photodétecteur.

Lorsque ledit support présente une face polie et une autre face dépolie, la couche de verre scintillant est déposée de préférence sur ladite autre face dépolie et est optiquemment couplée à la fenêtre d'entrée du photodétecteur par l'intermédiaire de ladite face polie.

De préférence, la couche de verre scintillant est métallisée en surface.

Enfin, lorsque ledit photoscintillateur est destiné à l'étude de particules $\alpha$, la couche de verre scintillant a de préférence une épaisseur de l'ordre du parcours, dans ledit verre scintillant, correspondant à l'énergie d'émission desdites particules $\alpha$, de façon que la lumière résultant de l'absorption de particules $\beta$ (électrons ou positrons) ou de photons $\gamma$ par le photoscintillateur, soit négligeable devant celle qui resulte de l'absorption desdites particules $\alpha$.

D'autres caractéristiques et avantages de l'invention apparaîtront mieux à la lecture de la description qui suit d'exemples de réalisation donnés à titre indicatif et nullement limitatif, en référence aux dessins annexés sur lesquels:

- la figure 1 est une vue schématique d'une installation pour la mise en oeuvre du procédé selon l'invention,

- la figure 2 est une vue schématique d'une réalisation particulière d'un photoscintillateur comportant une couche de verre scintillant obtenue par le procédé objet de l'invention, et

- la figure 3 est une vue schématique d'une autre réalisation particulière d'un photoscintillateur comportant une couche de verre scintillant formée, par le procédé objet de l'invention, directement sur la fenêtre d'entrée d'un photomultiplicateur que comporte le photoscintillateur.

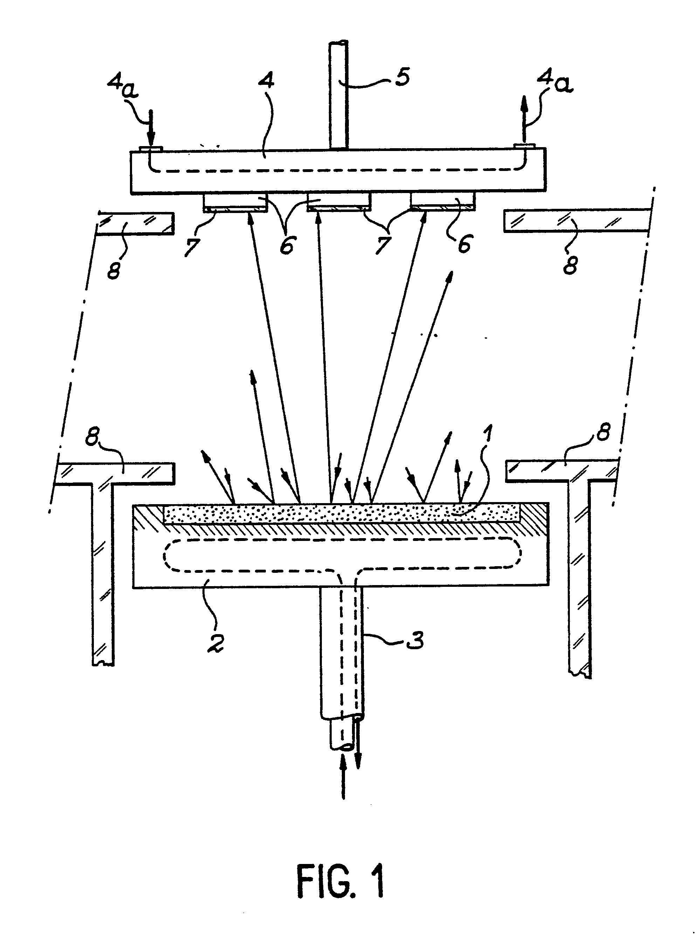

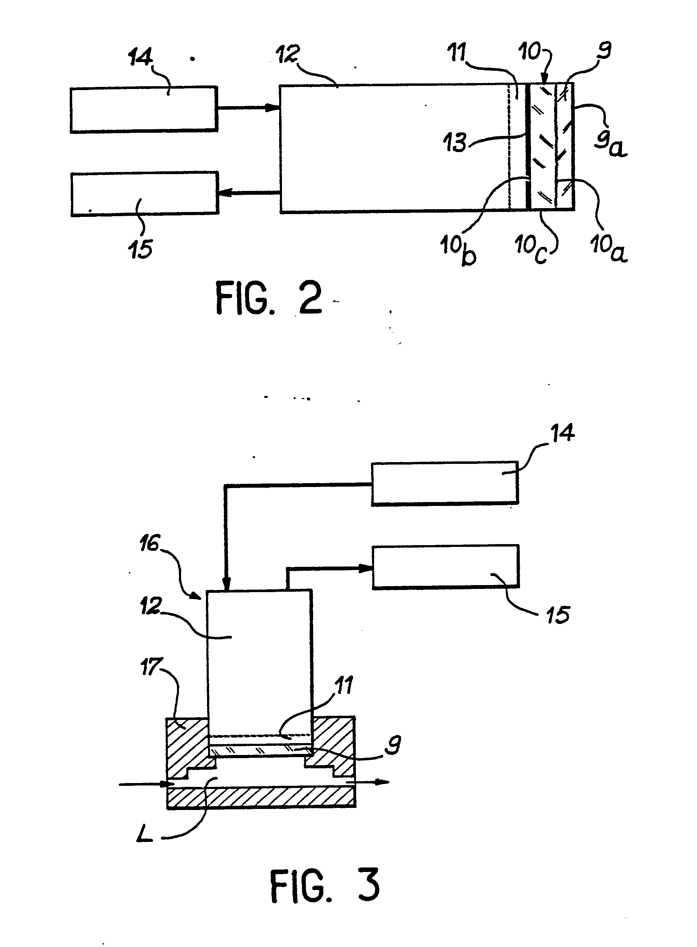

Sur la figure 1, on a représenté schématiquement une installation pour la mise en oeuvre du procédé objet de l'invention. Cette installation permet de former au moins une couche de verre luminescent sur un support par pulverisation cathodique haute fréquence. Elle permet en particulier de former une couche de verre scintillant sur un support pour réaliser un photoscintillateur comme on le verra lors de la description des figures 2 et 3.

Cette installation de pulvérisation cathodique haute fréquence, prévue pour obtenir des dépôts de très haute pureté, est connue dans l'état de la technique et décrite dans l'article de C. SELLA et F. JACQUES intitulé "Module de pulvérisation multimode dans des conditions de très haute pureté" et publié dans la revue "Le Vide - Les Couches Minces", supplément au n° 196, 1979, page 211.

Cette installation comprend une enceinte (non représentée sur la figure 1) dans laquelle un vide initial (avant pulvérisation) de l'ordre de $10^{-6}$Pa est réalisé par exemple à l'aide d'une pompe turbomoléculaire et d'une pompe à sublimation de titane (non représentées sur la figure 1), de façon à réduire fortement la pollution due aux impuretés de l'atmosphère résiduelle. L'installation comprend par ailleurs, dans l'enceinte,

- une cible 1 de l'ordre de 8 cm de diamètre par exemple et disposée dans un porte-cible 2 porté à une tension haute fréquence (par exemple 13 MHz) de l'ordre de -1500 à -2000 V par une électrode 3 permettant également l'amenée et l'évacuation d'eau pour le refroidissement de la cible 1,

- un porte-substrat 4 mis à la masse par un conducteur 5, refroidi par une circulation d'eau 4a et prévu pour recevoir des substrats ou supports 6 par exemple en quartz sur lesquels on désire par exemple former des couches de verre scintillant 7, et

- des écrans suppresseurs 8 recouverts d'un épais dépôt de silice pure et permettant de réduire la pollution due à des pulvérisations parasites qui introduiraient dans les couches à former des impuretés gênantes telles que Fe, Ca, Na et K qui sont des poisons pour la luminescence.

On réalise de préférence des dépôts sur plusieurs supports 6 à la fois plutôt que sur un seul, de façon à avoir un meilleur rendement de fabrication.

La cible 1 est constituée d'un mélange de poudre de silice très pure et d'un composé luminophore (c'est-à-dire apte à donner des centres luminescents) comme par exemple l'oxyde de cérium $Ce_2O_3$ ou l'oxyde $CeO_2$ (ou un mélange des deux), d'autres luminophores que le cérium pouvant bien entendu être utilisés. La proportion de cérium dans la cible 1 est de l'ordre de 1 à 6% en masse, par exemple 4%. On peut également ajouter à la cible des oxydes d'aluminium, de magnésium ou de lithium pour favoriser la luminescence des couches de verre scintillant obtenues. Le lithium permet par ailleurs d'obtenir des couches de verre scintillant utilisables pour réaliser des photoscintillateurs détection de neutrons.

La pulvérisation cathodique est effectuée dans un mélange d'un gaz inerte, tel que l'argon, et d'hydrogène présent dans ce mélange dans une proportion de 5 à 10% en volume. Les gaz utilisés sont de préférence de très haute pureté (N55). La pression du mélange gazeux pendant la pulvérisation est comprise entre 0,1 et 1 Pa.

De façon connue, un plasma comportant les ions argon $A^+$ est formé entre la cible 1 et les supports 6, dans la zone de l'enceinte délimitée par les écrans suppresseurs 8. Les ions $A^+$ sont attirés par la cible 1, viennent la frapper et la pulvérisent, "arrachant" ainsi des atomes Si, O et Ce à celle-ci, atomes qui sont projetés sur les supports 6 pour y former des couches 7. La pulvérisation se faisant de façon statistique, la composition des couches 7 obtenues correspond bien à celle d'un verre scintillant contenant de 1 à 6 % de cérium.

L'hydrogène favorise la formation d'ions $Ce^{3+}$ (centres luminescents) dans le verre scintillant, c'est-à-dire la disparition des ions $Ce^{4+}$ qui sont des poisons pour la luminescence. En fait, la pulvérisation est effectuée pendant quelques heures avant de réaliser les couches 7 de façon que le porte-substrat 4 soit recouvert de silice puis le vide est cassé et les supports 6 introduits. Les précautions prises pour la réalisation des couches 7 de verre scintillant (écrans suppresseurs 8, vide initial poussé) permettent d'obtenir dans lesdites couches une quantité d'impuretés de l'ordre de quelques parties par million.

On peut déterminer à l'avance l'épaisseur des couches que l'on désire former: ainsi une puissance haute fréquence de l'ordre de 300 W pour la cible 1 (de l'ordre de 8 cm de diamètre), permet-elle par exemple d'obtenir une vitesse de dépôt de 0,2 μm par heure. Une telle vitesse conduit à des couches 7 de bonne qualité, c'est-à-dire compactes et bien adhérentes aux supports 6 et dont l'épaisseur peut atteindre 10 à 20 μm.

Les couches 7 de verre scintillant au cérium obtenues ne présentant qu'une très faible luminescence lorsqu'elles sont excitées (par exemple par des particules α) sont en outre soumises à un traitement thermique tel qu'un recuit, en atmosphère inerte composée d'un gaz comme l'argon ou l'azote ou en atmosphère réductrice composée d'un tel gaz inerte et d'hydrogène ( à raison de 5 à 10% d'hydrogène en volume), dans un four à balayage gazeux de type connu dans l'état de la technique et non représenté. Dans ce four, les couches 7 sur leurs supports 6 sont alors par exemple portées à des températures de l'ordre de 700 à 1000°C pendant 1 à 5 heures. Ce traitement thermique permet d'éliminer en majeure partie les ions $Ce^{4+}$ qui sont défavorables à la luminescence comme on l'a déjà vu. Au lieu d'effectuer ce traitement thermique dans un four, on pourrait l'effectuer dans ladite enceinte pendant la formation des couches 7, par chauffage des supports 6 à une température de l'ordre de 500 à 1000°C.

Dans l'installation représentée sur la figure 1, on pourrait déposer non pas une mais plusieurs couches de verres luminescents différents successivement sur un même support, en disposant d'autant de cibles que de couches à réaliser, cibles que l'on bombarderait successivement, ou en utilisant une seule cible dont on changerait la composition après le dépôt d'une couche avant de réaliser la suivante.

Au lieu de supports 6, on peut placer dans ladite enceinte un ou plusieurs photodétecteurs tels que des photomultiplicateurs, protégés pour ne laisser apparaître que leur fenêtre d'entrée, de façon à obtenir des couches de verre scintillant directement sur cette fenêtre d'entrée (comme on le verra à propos de la figure 3). On obtient ainsi des ensembles de détection intégrés. C'est l'un des avantages du procédé objet de l'invention.

Sur la figure 2, on a représenté schématiquement un photoscintillateur par exemple destiné à la détection de particules α et muni d'une couche 9 de verre scintillant par exemple au cérium déposée sur un support 10 en quartz par le procédé objet de l'invention, dans une installation de pulvérisation cathodique. (Cette couche a également été traitée thermiquement comme on l'a expliqué). De plus, la couche 9 de verre scintillant est réalisée de façon à avoir une épaisseur de l'ordre du parcours, dans ledit verre scintillant, correspondant à l'énergie d'émission des particules α incidentes, de façon à obtenir une détection sélective de ces particules.

Le support 10, ayant par exemple une forme de plaque, est optiquement couplé à la fenêtre d'entrée 11 d'un photomultiplicateur 12 à l'aide d'un liquide 13 d'indice voisin du quartz et du verre constituant ladite fenêtre d'entrée 11. Ce liquide est par exemple une huile silicone. Le photomultiplicateur 12 est bien entendu électriquement relié à des moyens 14 d'alimentation en haute tension et à des moyens électroniques 15 d'amplification, de sélection et de comptage.

Lorsque le support 10 présente une face 10a dépolie et une autre face 10b polie, la couche 9 est de préférence déposée sur la face 10a dépolie et le support 10 est couplé à la fenêtre d'entrée 11 du photomultiplicateur 12 par sa face 10b polie, de façon à favoriser la transmission de la lumière émise par la couche 9 au photomultiplicateur 12.

Pour la même raison, on peut déposer suivant une technique connue une couche métallique réflectrice par exemple de l'ordrede 500 à 1000 Å (50 à 100 nm) sur la surface 9a de la couche de verre scintillant 9. Cette couche métallique réflectrice est par exemple en aluminium ou mieux en platine pour un photoscintillateur devant resister à des agents chimiques corrosifs. On améliore également ladite transmission de lumière en favorisant la réflexion de cette lumière sur le pourtour ou tranche 10c du support 10, par métallisation de ce pourtour ou en donnant à ce dernier une forme permettant la réflexion totale de la lumière.

On peut améliorer, en la simplifiant, la liaison optique entre la couche 9 de verre scintillant et le photomultiplicateur 12, en déposant directement cette couche 9 sur la fenêtre d'entrée 11 préalablement dépolie du photomultiplicateur 12 par le procédé objet de l'invention. Un photoscintillateur 16 comportant une couche scintillante 9 déposée sur la fenêtre d'entrée 11 est représenté schématiquement sur la figure 3. Pour les raisons exposées plus haut, la couche 9 peut être métallisée en surface.

Sur la figure 3, le photoscintillateur 16 est par exemple prévu pour mesurer le taux d'émission de particules α d'un liquide L radioactif et corrosif circulant dans une canalisation principale non représentée. L'épaisseur de la couche 9 de verre scintillant est de l'ordre du parcours, dans ledit verre scintillant, correspondant à l'énergie d'émission desdites particules α au sein du liquide L, soit, une épaisseur pouvant être de l'ordre de 10 à 15 μm. Par ailleurs, le photoscintillateur 16 est monté sur une canalisation 17 dérivée de ladite canalisation principale de façon que la couche scintillante 9 soit au contact du liquide L.

Le procédé objet de l'invention permet donc de réaliser de façon reproductible et à l'échelon industriel des couches de verre luminescent minces, dont l'épaisseur peut être de l'ordre de 10 μm. Il s'applique particulièrement bien à la réalisation de photoscintillateurs pour détection de particules α, nécessitant, pour avoir une bonne discrimination de ces particules vis-à-vis de particules β ou de photons γ, des couches scintillantes d'épaisseur pouvant ne pas dépasser 10 à 15 μm. Par ailleurs, la résistance du verre les couches scintillantes de ces photoscintillateurs peuvent être mises en contact direct avec un liquide corrosif émetteur α. De plus, le procédé objet de l'invention permet de réaliser des photoscintillateurs intégrés, la couche scintillante étant directement déposée sur la fenêtre d'entrée de photomultiplicateurs.

**Revendications**

1. Procédé d'obtention de couches minces de verres luminescents, caractérisé en ce qu'il consiste à projeter sur un support (6), par pulvérisation cathodique, en atmosphère réductrice, de la matière d'au moins une cible (1), chaque cible (1) comprenant de la silice et au moins un composé chimique apte à donner des centres luminescents, de façon à former au moins une couche mince (7) de verre luminescent sur ledit support (6).

2. Procédé selon la revendication 1, caractérisé en ce qu'il consiste en outre à effectuer un traitement thermique des couches (7) formées, pendant leur formation.

3. Procédé selon la revendication 1, caractérisé en ce qu'il consiste en outre à effectuer un traitement thermique des couches (7) formées, après leur formation.

4. Procédé selon la revendication 3, caractérisé en ce que ledit traitement thermique est effectué en atmosphère inerte.

5. Procédé selon la revendication 3, caractérisé en ce que ledit traitement thermique est effectué en atmosphère réductrice.

6. Procédé selon l'une quelconque des revendications 1 à 5, caractérisé en ce que chaque composé chimique comprend au moins un élément de la famille des Terres Rares.

7. Procédé selon la revendication 6, caractérisé en ce que ledit élément est le cérium.

8. Application du procédé selon l'une quelconque des revendications 1 à 7 à la réalisation de dispositifs munis d'au moins une couche mince de verre luminescent.

9. Application du procédé selon l'une quelconque des revendications 1 à 7 à la réalisation de photoscintillateurs comprenant une couche mince (9) de verre scintillant sur un support (10), cette couche (9) étant apte à émettre de la lumière par absorption d'énergie et optiquement couplée à un photodétecteur (12) muni d'une fenêtre d'entrée (11).

10. Application selon la revendication 9, caractérisée en ce que ledit support (10) est la fenêtre d'entrée (11) préalablement dépolie du photodétecteur (12).

11. Application selon la revendication 9, caractérisée en ce que ledit support (10) est transparent à la lumière que la couche (9) de verre scintillant est apte à émettre et destiné à être optiquement couplé à la fenêtre d'entrée (11) du photodétecteur.

12. Application selon la revendication 11, caractérisée en ce que ledit support (10) présentant une face polie (10b) et une autre face dépolie (10a), la couche (9) de verre scintillant est déposée sur ladite autre face dépolie (10a) et est optiquement couplée à la fenêtre d'entrée (11) du photodétecteur par l'intermédiaire de ladite face polie (10b).

13. Application selon l'une quelconque des revendications 9 à 12, caractérisée en ce que la couche (9) de verre scintillant est métallisée en surface.

14. Application selon l'une quelconque des revendications 9 à 13, caractérisée en ce que, ledit photoscintillateur étant destiné à l'étude de particule α, la couche (9) de verre scintillant a une épaisseur de l'ordre du parcours, dans ledit verre scintillant, correspondant à l'énergie d'émission desdites particules α.


**Patentansprüche**

1. Verfahren zur Herstellung von dünnen, lumineszierenden Glasschichten, <u>gekennzeichnet</u> durch Aufsprühen wenigstens eines Targetmaterials (1) auf eine Unterlage (6) durch kathodische Zerstäubung in reduzierender Atmosphäre, wobei jedes Target (1) aus Silicium und wenigstens einer chemischen Verbindung besteht, die dazu geeignet ist, lumineszente Zentren zu ergeben derart, daß wenigstens eine dünne Schicht (7) aus lumineszierendem Glas auf der Unterlage (6) ausgebildet wird.

2. Verfahren nach Anspruch 1, dadurch <u>gekennzeichnet</u>, daß weiterhin eine thermische Behandlung der gebildeten Schichten während ihrer Ausbildung durchgeführt wird.

3. Verfahren nach Anspruch 1, dadurch <u>gekennzeichnet</u>, daß weiterhin eine thermische Behandlung der gebildeten Schichten (7) nach ihrer Ausbildung durchgeführt wird.

4. Verfahren nach Anspruch 3, dadurch <u>gekennzeichnet</u>, daß die thermische Behandlung in inerter Atmosphäre ausgeführt wird.

5. Verfahren nach Anspruch 3, dadurch <u>gekennzeichnet</u>, daß die thermische Behandlung in reduzierender Atmosphäre ausgeführt wird.

6. Verfahren nach einem der Ansprüche 1 bis 5, dadurch <u>gekennzeichnet</u>, daß jede chemische Verbindung wenigstens ein Element der Familie der seltenen Erden enthält.

7. Verfahren nach Anspruch 6, dadurch <u>gekennzeichnet</u>, daß das Element Cer ist.

8. Anwendung des Verfahrens nach einem der Ansprüche 1 bis 7 bei der Herstellung von Einrichtungen, die mit wenigstens einer dünnen lumineszierenden Glasschicht versehen sind.

9. Anwendung des Verfahrens nach einem der Ansprüche 1 bis 7 bei der Herstellung von Photoszintillatoren, die eine dünne Schicht (9) aus szintillierendem Glas auf einer Unterlage (10) enthalten, wobei diese Schicht (9) dazu geeignet ist, Licht durch Absorption abzugeben und optisch mit einem Photodetektor (12) gekuppelt ist, der mit einem Eintrittsfenster (11) versehen ist.

10. Anwendung nach Anspruch 9, dadurch <u>gekennzeichnet</u>, daß die Unterlage (10) das zuvor mattierte Eintrittsfenster (11) des Photodetektors (12) ist.

11. Anwendung nach Anspruch 9, dadurch <u>gekennzeichnet</u>, daß die Unterlage (10) für das Licht, das die Schicht (9) aus szintillierendem Glas abzugeben in der Lage ist, transparent ist und dazu bestimmt ist, optisch mit dem Eintrittsfenster (11) des Photodetektors gekuppelt zu werden.

12. Anwendung nach Anspruch 11, dadurch <u>gekennzeichnet</u>, daß die Unterlage (10) eine polierte Fläche (10b) und eine weitere mattierte Fläche (10a) aufweist, wobei die Schicht (9) aus szintillierendem Glas auf die andere mattierte Fläche (10a) aufgebracht und optisch mit dem Eintrittsfenster (11) des Photodetektors vermittels der genannten polierten Fläche (10b) verbunden ist.

13. Anwendung nach einem der Ansprüche 9 bis 12, dadurch <u>gekennzeichnet</u>, daß die Schicht (9) aus szintillierendem Glas auf der Oberfläche metallisiert ist.

14. Anwendung nach einem der Ansprüche 9 bis 13, dadurch <u>gekennzeichnet</u>, daß der Photoszintillator für die Untersuchung von α-Partikeln bestimmt ist, die Schicht (9) aus szintillierendem Glas eine Dicke in der Größenordnung der Reichweite in dem szintillierenden Glas entsprechend der Emissionsenergie der genannten α-Partikel hat.


**Claims**

1. A process for obtaining thin layers of luminescent glass, characterised in that it consists of projecting the material of at least one target (1) onto a support (6) by cathodic atomisation in a reducing atmosphere, each target (1) comprising silica and at least one chemical compound adapted to provide luminescent nuclei, whereby to form at least one thin layer (7) of luminescent glass on said support (6).

2. A process according to Claim 1, characterised in that it additionally comprises a heat treatment of the layers (7) produced during the course of their formation.

3. A process according to Claim 1, characterised in that additionally comprises a heat treatment of the layers (7) produced, after their formation.

4. A process according to Claim 3, characterised in that said heat treatment is conducted in an inert atmosphere.

5. A process according to Claim 3, characterised in that said heat treatment is conducted in a reducing atmosphere.

6. A process according to any one of Claims 1 to 5, characterised in that each chemical compound comprises at least one element of the rare earth group.

7. A process according to Claim 6, characterised in that said element is cerium.

8. Application of a process according any one of Claims 1 to 7 to the production of apparatus having at least one thin layer of luminescent glass.

9. Application of the process according to any one of Claims 1 to 7 to the formation of photoscintillators comprising a thin layer (9) of scintillating glass on a support (10), said layer (9) being adapted to emit light on absorption of energy, and optically coupled to a photodetector (12) having an inlet window (11).

10. Application according to Claim 9, characterised in that said support (10) is the previously-frosted inlet window (11) of the photodetector (12).

11. Application according to Claim 9, characterised in that said support (10) is transparent to the light which the layer (9) of scintillating glass is adapted to emit, and is destined to be optically coupled to the inlet window (11) of a photodetector.

12. Application according to Claim 11, characterised in that said support (10) has one polished surface (10b) and another frosted surface (10a), the layer (9) of scintillating glass is deposited on said other frosted surface (10a) and is optically coupled to the inlet window (11) of a photodetector through said polished surface (10b).

13. Application according to any one of Claims 9 to 12, characterised in that the layer (9) of scintillating glass has a metallised surface.

14. Application according to any one of Claims 9 to 13, characterised in that, said photoscintillator being adapted for the study α-particles, the layer 9) of scintillating glass has a thickness of the order of the absorption depth, within said scintillating glass, corresponding to the emission energy of said α-particles.

0 063 989

FIG. 1

1

FIG. 2

FIG. 3